# EUROPÄISCHE PATENTSCHRIFT

(11) **EP 0 650 189 B1**
(45) Veröffentlichungstag und Bekanntmachung des Hinweises auf die Patenterteilung: **21.08.1996**
(21) Anmeldenummer: 93117215.9
(22) Anmeldetag: 22.10.1993
(51) Int. Cl.: H01L 21/603, B23K 20/02

(54) **Verfahren zum Herstellen eines Halbleiter-Modulaufbaus**
Method of manufacture of a semiconductor module
Procédé de fabrication d'un module semi-conducteur

(43) Veröffentlichungstag der Anmeldung: 26.04.1995
(73) Patentinhaber: SIEMENS AKTIENGESELLSCHAFT, 80333 München (DE)
(72) Erfinder: Kuhnert, Reinhold, Dr., Dipl.-Phys., D-80637 München (DE); Schwarzbauer, Herbert, Dr., Dipl.-Min., D-81373 München (DE)

(56) Entgegenhaltungen:
- EP-A- 0 330 895
- DE-A- 3 917 765
- DE-A- 3 940 933

## Beschreibung

Die Erfindung bezieht sich auf ein Verfahren zum Herstellen eines Halbleiter-Modulaufbaus mit einer metallenen Bodenplatte, mit einem mit der Bodenplatte stoffschlüssig verbundenen, mit einer Metallisierung versehenen Keramiksubstrat und mit mit der Metallisierung stoffschlüssig verbundenen Halbleiterkörper, bei dem die Bodenplatte durch einen Preßstempel konvex verformt wird.

Ein Verfahren dieser Art ist z. B. in der DE-A 39 40 933 beschrieben worden. Hier wird ein bereits verlöteter Modulaufbau mit der Bodenplatte auf eine bezüglich der Bodenplatte konkave Preßform gelegt. Dann wird die Form bis knapp unter die Schmelztemperatur des Lotes erwärmt und die metallene Bodenplatte wird durch einen Preßstempel verformt, dessen Form der Preßform angepaßt ist. Dabei wird der Druckstempel auf die Längskanten der Bodenplatte aufgesetzt. Durch das Verformen der Bodenplatte wird der Bimetalleffekt kompensiert, der sich aus der stoffschlüssigen Verbindung von Keramiksubstrat und Bodenplatte ergibt. Dabei baut sich die mechanische Spannung zwischen Substrat und Bodenplatte durch plastische Verformung in der Lotschicht ab. Die Kompensation führt dazu, daß die Bodenplatte konvex bezüglich eines Kühlkörpers geformt ist und durch Schrauben plan an den Kühlkörper angelegt werden kann.

Der Erfindung liegt die Aufgabe zugrunde, ein Verfahren der genannten Art so weiterzubilden, daß die Wölbung der Bodenplatte und die Verbindungsschicht zwischen Bodenplatte und Keramiksubstrat in einem einzigen Arbeitsgang erzeugtwerden.

Diese Aufgabe wird dadurch gelöst, daß die Halbleiterkörper, das Keramiksubstrat und die Bodenplatte in eine Elastomer-Preßform eingelegt werden, daß auf die Bodenplatte ein beheizbarer Preßstempel mit einer bezüglich der Bodenplatte konkaven Oberfläche aufgesetzt wird und mindestens die Bodenplatte und das Keramiksubstrat unter gegen Zimmertemperatur erhöhter Temperatur durch den Druck des Preßstempels verformt und verbunden werden.

Weiterbildungen der Erfindung sind Gegenstand der Unteransprüche.

Die Erfindung wird anhand von Ausführungsbeispielen in Verbindung mit den Figuren 1 bis 4 näher erläutert. Es zeigen:
- Figur 1: einen Schnitt durch eine Preßform mit eingelegten Teilen eines Halbleiter-Modulaufbaus,
- Figur 2: eine Seitenansicht auf einen durch die Einrichtung nach Figur 1 verformten Modulaufbau,
- Figur 3: eine erste für die Verbindung der genannten Teile geeignete Schichtfolge und
- Figur 4: eine zweite für die Verbindung der genannten Teile geeignete Schichtfolge.

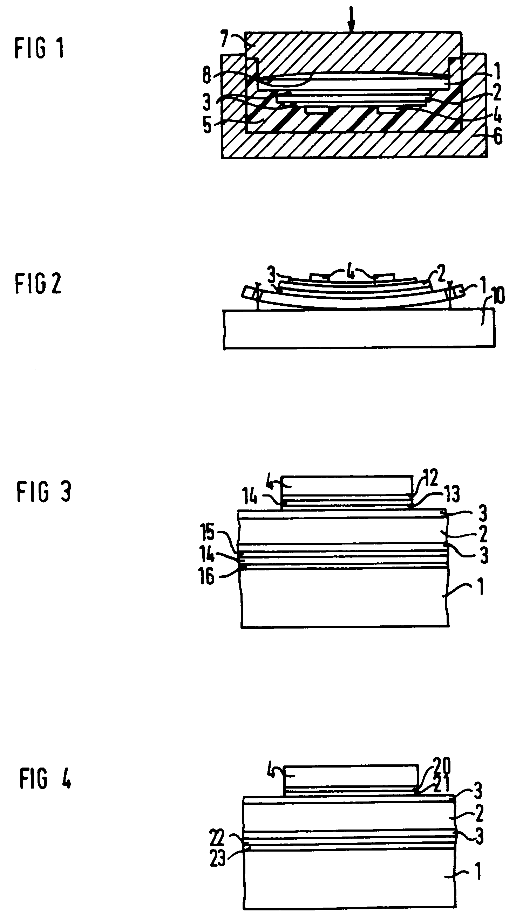

Der Modulaufbau nach Figur 1 enthält eine metallene Bodenplatte 1, ein Keramiksubstrat 2 und Halbleiterkörper 4. Das Keramiksubstrat 2 ist beidseitig mit Metallisierungen 3 versehen, die z. B. nach dem DCB-(Direct Copper Bonding) Verfahren aufgebrachte Kupferleiterbahnen sein können. Die Metallisierungen 3 können jedoch auch aus anderen Metallen bestehen und dünner sein als nach dem DCB-Verfahren aufgebrachte Metallschichten. Eine von ihnen muß jedoch mittelbar oder unmittelbar mit der metallenen Bodenplatte 1 stoffschlüssig verbindbar sein. Die andere Metallisierung 3 liegt zwischen dem Keramiksubstrat 2 und den Halbleiterkörpern 4. Diese Metallisierung muß den Halbleiterkörpern 4 entweder unmittelbar oder mittelbar eine stoffschlüssige Befestigung erlauben.

Die Teile des Modulaufbaus werden derart in eine Elastomerform 5 eingelegt, daß die Halbleiterkörper zu unterst liegen, darauf das Keramiksubstrat liegt und auf dieser die Bodenplatte 1. Die Elastomerform besteht aus elastisch verformbarem Material, z. B. aus Silikonkautschuk. Sie wird in eine Aufnahmeform 6 eingelegt, die die Elastomerform 5 seitlich und unten lückenlos umschließt. Auf die Bodenplatte 1 wird ein beheizbarer Preßstempel 7 aufgesetzt, der eine bezüglich der Bodenplatte 1 konkav gewölbte Oberfläche 8 hat. Der Preßstempel schließt außerdem die Elastomerform 5 nach oben ab.

Der beheizte Preßstempel wird dann gegen die Bodenplatte 1 gedrückt. Das Elastomer verformt sich elastisch und überträgt den Druck quasihydrostatisch auf den gesamten Modulaufbau. Dabei verformt sich die Bodenplatte und mindestens das Keramiksubstrat entsprechend der Form der Oberfläche 8 des Preßstempels 7. Wie groß der Druck und die Temperatur des Preßstempels sein müssen, hängt von der Art der stoffschlüssigen Verbindung zwischen Bodenplatte und Keramiksubstrat einerseits und Keramiksubstrat und Halbleiterkörper 4 andererseits ab. Die Teile können z. B. durch Verlöten, durch Drucksintern oder durch Diffusionsschweißen verbunden werden. Ausführungsbeispiele dazu werden in Verbindung mit den Figuren 3 und 4 angegeben.

Der verbundene und verformte Modulaufbau ist schematisch in Figur 2 gezeigt. Die Verformung ist hier übertrieben stark dargestellt. Es ist ersichtlich, daß der Modulaufbau konvex bezüglich eines Kühlkörpers 10 verformt ist, auf den er montiert werden soll.

Der Modulaufbau kann dann durch Schrauben, die durch in der Bodenplatte 1 angebrachte Löcher gesteckt sind, plan an den Kühlkörper 10 angelegt werden. Die konvexe Verformung muß so stark sein, daß die konvexe Form auch im Betriebszustand des Moduls erhalten bleibt. Die in der Preßform nach Figur 1 enthaltene Konvexität ist dabei stets größer als bei Zimmertemperatur oder im Betriebszustand. Der Betrag der Verformung richtet sich nach der Länge und Dicke der metallenen Bodenplatte 1, der Länge und Dicke des Keramiksubstrats 2 und nach den thermischen Ausdehnungskoeffizienten beider Teile. So hat sich z. B. bei einer aus Kupfer bestehenden Bodenplatte 1 von 90 mm Länge und einer Dicke von 3 bis 4 mm, einem 630 µm starken Keramiksubstrat, einer Verbindungstemperatur zwischen 200 und 240 °C eine Konvexität von 600 µm bewährt, gemessen zwischen Bodenmitte und Bodenenden. Die Restkonvexität betrug dann bei Zimmertemperatur noch 200 µm.

Es ist auch möglich, einen Modulaufbau in die Preßform einzulegen, dessen Teile bereits durch Verlöten miteinander verbunden sind. Dann muß die Temperatur beim Verformen unterhalb der Schmelztemperatur des Lots liegen und so hoch sein, daß das Lot gut plastisch verformbar ist. Es empfiehlt sich jedoch, das Verformen des Modulaufbaus und das Verbinden seiner Einzelteile gleichzeitig vorzunehmen. Hierzu sind die Halbleiterkörper, das Keramiksubstrat und die Bodenplatte jeweils mit geeigneten Metallschichten versehen, die das obengenannte Drucksintern oder das Diffusionsschweißen ermöglichen.

In Figur 3 ist ein Modulaufbau mit einer Schichten folge dargestellt, die für das Drucksintern geeignet ist. Gleiche Teile wie in Figur 1 und 2 sind mit gleichen Bezugszeichen versehen. Der aus Silizium bestehende Halbleiterkörper 4 trägt auf der Unterseite eine Metallschicht. Diese bildet den Kontakt zum Keramiksubstrat. Die Metallschicht 12 kann in bekannter Weise einen mehrschichtigen Aufbau haben, der am Silizium beginnend die Schichtfolge Aluminium/Titan/Nickel/Silber hat. Die obere, dem Halbleiterkörper 4 zugewandte Metallisierung 3 des Keramiksubstrats 1 trägt eine Silberschicht 13. Zwischen der Silberschicht der Metallschicht 12 und der Silberschicht 13 wird eine hauptsächlich aus Silber bestehende Sinterpaste 14 aufgetragen. Entsprechend hat die der Bodenplatte 1 zugewandte Metallisierung 3 des Keramiksubstrats 2 eine Silberschicht 15. Die Bodenplatte 1 trägt eine Silberschicht 16. Zwischen beiden Silberschichten wird wieder eine Sinterpaste 14 aufgetragen.

Die Sinterpaste 14 besteht im wesentlichen aus kleinkörnigem Silberpulver, das in einem Lösungsmittel suspendiert ist. Nach dem Auftragen der Sinterpaste 14 und dem Zusammenfügen der Teile wird die Sinterpaste zunächst getrocknet. Danach wird der nur lose zusammengefügte Aufbau nach Figur 3 wie in Zusammenhang mit Figur 1 beschrieben in die Elastomerform eingelegt und dann z. B. bei einer Temperatur von 230 °C und einem Druck von mehr als 900 N/cm², z. B. 3000-4000 N/cm² zusammengepreßt. Der genaue Vorgang des Drucksinterns und die genaue Zusammensetzung der Sinterpaste 14 ist nicht Gegenstand der vorliegenden Erfindung. Die wesentlichen Parameter sind der eingangs erwähnten EP-A 0 330 895 zu entnehmen.

Die für das Diffusionsschweißen erforderliche Schichtfolge ist in Figur 4 dargestellt. Der Halbleiterkörper 4 ist auf der der Metallisierung 3 des Keramiksubstrats 2 zugewandten Seite mit einer Metallschicht 20 versehen. Diese kann wie im Ausführungsbeispiel nach Figur 3 eine Mehrlagenschicht sein, deren äußere, dem Keramiksubstrat 2 zugewandte Seite aus Silber besteht. Die dem Silizium zugewandte Metallisierung 3 des Keramiksubstrats 2 ist ebenfalls mit einer Silberschicht 21 versehen. Entsprechend trägt die Metallisierung 3 auf der der Bodenplatte 1 zugewandten Seite eine Silberschicht 22, die an eine auf die Bodenplatte 1 aufgebrachte Silberschicht 23 angrenzt. Der Aufbau nach Figur 4 wird dann nach dem in Verbindung mit Figur 1 beschriebenen Verfahren miteinander verbunden. Die Verbindungstemperatur kann zwischen 150 und 250 °C liegen, der Anpreßdruck in einem Bereich von 5000 bis 25 000 N/cm². Die genauen Schichtdicken und die genauen sonstigen Parameter bei der Herstellung der Anordnung nach Figur 4 sind nicht Gegenstand der vorliegenden Erfindung. Sie sind in der eingangs erwähnten EP-A 0 330 896 ausführlich beschrieben.

## Patentansprüche

1. Verfahren zum Herstellen eines Halbleiter-Modulaufbaus mit einer metallenen Bodenplatte, mit einem mit der Bodenplatte stoffschlüssig verbundenen, mit einer Metallisierung versehenen Keramiksubstrat und mit mit der Metallisierung stoffschlüssig verbundenen Halbleiterkörpern, bei dem die Bodenplatte durch einen Preßstempel konvex verformt wird,
**dadurch gekennzeichnet**, daß die Halbleiterkörper (4), das Keramiksubstrat und die Bodenplatte (1) in eine Elastomer-Preßform (5) eingelegt werden, daß auf die Bodenplatte ein beheizbarer Preßstempel (7) mit einer bezüglich der Bodenplatte konkaven Oberfläche aufgesetzt wird und mindestens die Bodenplatte und das Keramiksubstrat unter gegen Zimmertemperatur erhöhter Temperatur durch den Druck des Preßstempels verformt und verbunden werden.

2. Verfahren nach Anspruch 1,
**dadurch gekennzeichnet,** daß zwischen den Halbleiterkörpern (4), der Metallisierung (3) und der Bodenplatte (1) Metallschichten (12, 13; 15, 16) liegen, die die genannten Teile durch Drucksintern miteinander verbinden.

3. Verfahren nach Anspruch 1,
**dadurch gekennzeichnet**, daß zwischen den Halbleiterkörpern (4), der Metallisierung (3) und der Bodenplatte (1) Metallschichten (20, 21; 22, 23) liegen, die die genannten Teile durch Diffusionsschweißen miteinander verbinden.

4. Verfahren nach Anspruch 1,
**dadurch gekennzeichnet,** daß die Halbleiterkörper (4), die Metallisierung (3) und die Bodenplatte (1) vor dem Einlegen die Preßform (5) verlötet werden und daß die Temperatur beim Verformen niedriger als die Schmelztemperatur des Lotes ist.

## Claims

1. Method for the production of a semiconductor module structure, having a metal base plate, having a ceramic substrate, provided with a metallization and connected to the baseplate by positive interlocking, and having semiconductor bodies connected by positive interlocking to the metallization, in which method the baseplate is convexly deformed by a pressure ram, characterized in that the semiconductor bodies (4), the ceramic substrate and the baseplate (1) are placed in an elastomer pressure mould (5), in that a heatable pressure ram (7), having a surface which is concave relative to the baseplate, is applied to the baseplate, and at least the baseplate and the ceramic substrate are deformed and connected by the pressure of the pressure ram at a temperature higher than room temperature.

2. Method according to Claim 1, characterized in that metal layers (12, 13; 15, 16) are present between the semiconductor bodies (4), the metallization (3) and the baseplate (1), and connect together the said parts by pressure sintering.

3. Method according to Claim 1, characterized in that metal layers (20, 21; 22, 23) are present between the semiconductor bodies (4), the metallization (3) and the baseplate (1), and connect together the said parts by diffusion welding.

4. Method according to Claim 1, characterized in that the semiconductor bodies (4), the metallization (3) and the baseplate (1) are soldered before the pressure mould (5) is introduced, and in that the temperature during deformation is lower than the melting temperature of the solder.

## Revendications

1. Procédé de fabrication d'une structure de module de semiconducteur comportant une plaque métallique de fond, un substrat de céramique relié par coopération de matière à la plaque de fond et muni d'une métallisation, des corps semiconducteurs reliés par coopération de matière à la métallisation, dans lequel on déforme de manière convexe la plaque de fond par une matrice de pressage,
caractérisé en ce que l'on introduit les corps (4) semiconducteurs, le substrat de céramique et la plaque (1) de fond dans un moule (5) en élastomère, on pose sur la plaque de fond une matrice (7) de pressage pouvant être chauffée et ayant une surface concave par rapport à la plaque de fond, on déforme et on relie au moins la plaque de fond et le substrat de céramique, à température plus grande que la température ambiante, par pression de la matrice de pressage.

2. Procédé suivant la revendication 1,
caractérisé en ce qu'il y a entre les corps (4) semiconducteurs, la métallisation (3) et la plaque (1) de fond, des couches métalliques (12, 13 ; 15, 16), qui relient entre elles lesdites parties par frittage sous pression.

3. Procédé suivant la revendication 1,
caractérisé en ce qu'il y a entre les corps (4) semiconducteurs, la métallisation (3) et la plaque (1) de fond, des couches métalliques (20, 21 ; 22, 23), qui relient entre elles lesdites parties par soudage par diffusion.

4. Procédé suivant la revendication 1,
caractérisé en ce que l'on brase les corps (4) semiconducteurs, la métallisation (3) et la plaque (1) de fond avant l'introduction dans le moule (5) et la température lors de la déformation est plus petite que la température de fusion du métal d'apport de brasage.
